# EUROPÄISCHE PATENTSCHRIFT

(11) **EP 0 749 211 B1**
(45) Veröffentlichungstag und Bekanntmachung des Hinweises auf die Patenterteilung: **02.05.2003**
(21) Anmeldenummer: 96109275.6
(22) Anmeldetag: 10.06.1996
(51) Int. Cl.: H03M 13/00, H03M 13/27

(54) **Verfahren und Codiereinrichtung zur gesicherten Übertragung von Daten mittels Mehrkomponenten-Codierung**
Method and coding device for a secure transmission of data by means of a multi-component coding
Procédé et dispositif pour la transmission protégée de données au moyen d'un codage à composants multiples

(30) Priorität: 12.06.1995 DE 19521328
(43) Veröffentlichungstag der Anmeldung: 18.12.1996
(73) Patentinhaber: SIEMENS AKTIENGESELLSCHAFT, 80333 München (DE)
(72) Erfinder: Hagenauer, Joachim, Prof. Dr.-Ing., 82229 Seefeld (DE); Burkert, Frank, 80796 München (DE); Werner, Martin, Dr.-Ing., 36037 Fulda (DE)

(56) Entgegenhaltungen:
- EP-A- 0 414 368
- EP-A- 0 436 251
- EP-A- 0 511 141
- EP-A- 0 544 463
- BARBULESCU A S ET AL: "RATE COMPATIBLE TURBO CODES" ELECTRONICS LETTERS, Bd. 31, Nr. 7, 30. März 1995 (1995-03-30), Seite 535/536 XP000504301 ISSN: 0013-5194

## Beschreibung

Die Erfindung betrifft ein Verfahren zur gesicherten Übertragung von Daten nach dem Oberbegriff des Patentanspruchs 1 und außerdem eine geeignete Codiereinrichtung nach dem Oberbegriff der weiteren unabhängigen Ansprüche.

Bei der Übertragung von Information über gestörte Datenkanäle treten häufig Störungen auf. Diese Störungen können bei binärer Übertragung einzelne Bits oder Gruppen von Bits invertieren. Um diese Übertragungsfehler empfangsseitig erkennen und gegebenenfalls korrigieren zu können, werden sendeseitig zu den Informationsbits noch Kontrollbits hinzugefügt und übertragen. Eine Übersicht über die verbreitetsten Verfahren zur Kanalcodierung ist in J.G. Proakis "Digital Communications", McGraw-Hill International Editions, 1989 beschrieben.

C. Berrou stellte 1993 ein neues leistungsfähiges, auf der parallelen Verkettung von mindestens zwei rekursiven systematischen Faltungscodes und ihrer iterativen Decodierung basierendes Verfahren zur Kanalcodierung, die "Turbo-Codierung", vor.

Dieses Codierungsverfahren und damit zusammenhängende Details sind in den folgenden Literaturstellen ausführlich beschrieben:
- C. Berrou, "Near Shannon limit error-correcting and decoding: Turbo-Codes (1)", Proc. ICC'93, May 1993;
- Demande de brêvet européen, N. de publication: 0 511 141 A1, Inventeur: C.Berrou, "Procédé de codage correcteur d'erreurs à moins deux codages convolutifs systématiques en parallèle, procédé de décodage intératif, module de décodage correspondants"
- J. Hagenauer et al, "Iterative ("Turbo") decoding of systematic convolutional codes with MAP and SOVA algorithms", ITG Fachtagung "Codierung", München, Okt. 1994
- J. Hagenauer, L.Papke, "Decoding "Turbo"-Codes with the Soft Output Viterbi Algorithm (SOVA)", 1994 International Symposium on Information theory, Trondheim, 1994.

Bei einer Mehrkomponentencodierung, der sogenannten Turbo-Codierung, werden mehrere verkettete Komponentencodes parallel generiert. Die Coderate, das Verhältnis der Informationsbits zu der Gesamtheit von Informationsbits und Kontrollbits, ergibt sich aus den Coderaten der verwendeten Komponentencodes und einer Selektionsvorschrift, durch die aus den Codesymbolen der generierten Codefolgen eine Auswahl erfolgt. Auf diese Weise kann in einem weiten Bereich die Coderate festlegt werden, mit der allerdings die Fähigkeit zur Fehlerkorrektur bzw. Fehlererkennung eng verknüpft ist.

In der europäischen Patentanmeldung mit der Publikationsnummer 0 511 141 werden gemäß einer fest vorgegebenen Selektionsvorschrift (Punktierungsvorschrift) bestimmte Codesymbole aus den erzeugten Codefolgen ausgewählt. Diese Vorschrift ist natürlich auch dem Decoder bekannt.

Aus der Offenlegungsschrift DE 34 43 041 A1 ist ein Verfahren zur Verbesserung der Übertragungsqualität von Bildsignalen bekannt, das bei Störungen die Anzahl der Informationsbits reduziert und an deren Stelle. Kontrollbits eines fehlerkorrigierenden Codes übertägt. Durch einen Rückkanal sind Sendeund Empfangseinrichtung über den jeweiligen Übertragungsmode informiert. Dieses Verfahren ist jedoch bei der Übertragung von Daten und auch bei bereits reduzierten Sprach- oder Bildsignalen nicht anwendbar, da sämtliche Informationsbits benötigt werden. Verschiedene Coderaten erfordern hier jeweils eine eigene Codier- und Decodiereinrichtung.

Das Problem, zwischen unterschiedlichen Fehlerschutzstufen umschalten zu können, wird,durch das im Anspruch 1 angegebene Verfahren gelöst.

Eine Codier- und eine Decodiereinrichtung sind in unabhängigen Ansprüchen beschrieben.

Vorteilhafte Weiterbildungen der Erfindung sind in den abhängigen Ansprüchen angegeben.

Das Verfahren ist besonders vorteilhaft anwendbar, wenn wichtige Informationsabschnitte oder ausgewählte Bits mittels einer wählbaren "dynamischen" Auswahlvorschrift durch Erzeugung von zusätzlichen Kontrollbits in weiteren Codern einen besseren Fehlerschutz erhalten als andere Informationsabschnitte bzw. Bits geringerer Bedeutung.

Um den selektiv verbesserter Fehlerschutz zu erreichen, werden einigen Komponentencodern als Selektoren wirkende Filter vorgeschaltet, die jeweils nur die wichtigeren Informationsbits oder Informationsabschnitte an die weiteren Coder durchschalten.

Besonders günstig ist die Verwendung von Einfach-Paritäts-Codes zum Schutz der wichtigeren Informationsbits.

Es ist vorteilhaft, wenn die Auswahlvorschrift in einem Speicher eingeschrieben wird. Besonders bei einem löschbaren Speicher (EEPROM) oder bei einem Schreib-Lese-Speicher (RAM) wird eine besonders flexible Codierung möglich.

Dieses Verfahrens kann mit einem wählbaren Selektionsalgorithmus der codierten Codefolgen kombiniert werden. Hierdurch kann die Coderate und der damit verbundene Fehlerschutz in weiten Bereichen unterschiedlichen Diensten und Anforderungen angepaßt werden, ohne Änderungen bei der Coder- und Decodereinrichtung durchführen zu müssen.

Durch "dynamische" Selektion von Codesymbolen (Bits) der codierten Codefolgen innerhalb einer Informationssequenz kann bei Bedarf die Redundanz ungleichmäßig über die Informationsbits verteilt werden und damit der ungleichmäßige Fehlerschutz verstärkt werden.

Die Erfindung wird anhand von Figuren näher erläutert.

Es zeigen:
- Figur 1: ein Prinzipschaltbild einer erfindungsgemäßen Codiereinrichtung,
- Figur 2: eine zugehörige Decodiereinrichtung und
- Figur 3: einen Coder für einen rekursiven systematischen Code,

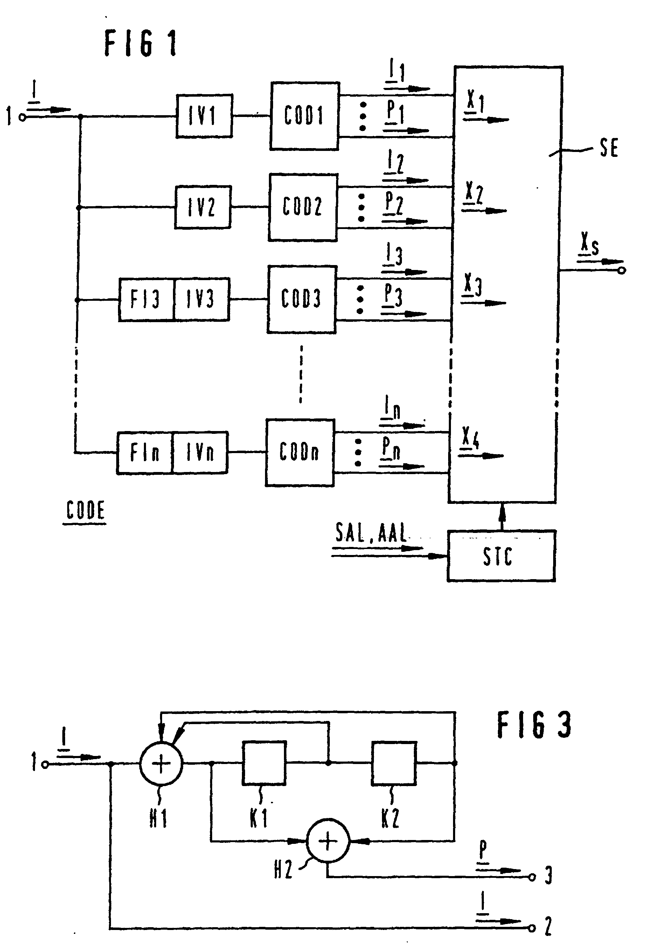

In **Figur 1** ist eine Codiereinrichtung CODE zur Erzeugung eines "Turbo-Codes" als Prinzipschaltbild dargestellt. Sie enthält mehrere Komponentencoder COD1 bis CODn, denen über Interleaver IV1 bis IVn eine Informationssequenz **I** zugeführt wird. Die Interleaver haben die Aufgabe, die Informationsbits in einer anderen zeitlichen Reihenfolge auszugeben. Dadurch soll erreicht werden, daß von Störungen im Übertragungskanal unterschiedliche Bits betroffen werden. Es können gleiche oder auch unterschiedliche Coder verwendet werden. Die dem Coder COD1 zugeführten Informationssequenz **I** wird unverändert am Informationsausgang 2 abgegeben; die erzeugte Kontrollseguenz **P**₁ wird am Kontrollausgang 3 abgegeben (es können auch jeweils mehrere Ausgänge für Informationsbits und Kontrollbits vorgesehen sein, wenn der Code eine Datenrate < 1/2 aufweist). Die Informationssequenz **I** und die Kontrollsequenz **P**₁ bilden die erste Codefolge **X**₁.

In derselben Weise werden von dem zweiten Komponentencoder COD2 aus verwürfelten Informationssequenz eine Codefolge erzeugt.

Mit Hilfe dieser Coder erhalten zunächst alle Informationsbits denselben Fehlerschutz.

Die dargestellte Codiereinrichtung führt aber mit Hilfe von weiteren Komponentencodern COD3 bis CODn und diesen vorgeschalteten als Selektoren wirkenden Filtern FI1 bis FIn eine Auswahl der wichtigeren Bits oder Bitfolgen der zu codierenden Informationssequenz **I** durch und erzeugt zu deren Schutz weitere Codefolgen **X**₃ bis **X**ₙ. Die ausgewählten Bits können beispielsweise sämtliche Bits von wichtigen Daten einer Informationssequenz oder auch die höchstwertigen Bits von PCMcodierten Sprachsignalen sein. Die zusätzlich erzeugten Codefolgen **X**₃ bis **X**ₙ werden ebenfalls übertragen. Durch diese angepaßte Codierung kann - verbunden mit einem geringeren Fehlerschutz für die restlichen Bits - die Gesamt-Übertragungsrate der ausgegebenen Codefolgen gesenkt werden.

Sämtliche erzeugten Codefolgen **X**₁ bis **X**ₙ werden einer Selektionseinrichtung SE zugeführt, die Codesymbole dieser Codefolgen auswählt (in Sonderfällen auch alle Codesymbole).

Die Selektionseinrichtung, die einem Multiplexers entspricht, wird hierbei von der Steuerung STC gesteuert. Diese verfügt außer den Kriterien für die Auswahl der wichtigen Bits auch über alle Kriterien zur Steuerung der Selektion.

Häufig ist es aus den unterschiedlichsten Gründen wünschenswert, unterschiedliche Coderaten zu realisieren.

Dies wird im wesentlichen durch die Auswahl einer unterschiedlichen Anzahl von Kontollbits erreicht.

Ausgegeben wird beispielsweise eine serielle Codefolge **X**ₛ, in der die Bits der Informationsequenz meistens nur einmal enthalten sind.

Der Auswahlalgorithmus AAL für die besonders zu schützenden Informationsbits und der Selektionsalgorithmus SAL für die erzeugten Codefolgen werden in einen Speicher M eingegeben. Entsprechend der erforderlichen Flexibilität, kann dies ein RAM oder ROM sein. In einigen Fällen kann auch eine hardwaremäßige Verdrahtung als "Speicher" Verwendung finden.

Die Änderung des Auswahl- und/oder der Selektionsvorschriften kann sowohl in festen Zyklen als auch beispielsweise bei einer sich verschlechternden Übertragungsqualität während der Verbindung erfolgen. Ebenso können für bestimmte Phasen einer Verbindung, beispielsweise während des Verbindungsaufbaus, andere Auswahl- und/oder Selektionsvorschriften angewendet werden.

Der Selektionsalgorithmus SAL für die erzeugten Codefolgen wird - unter Berücksichtigung der Eigenschaften der erzeugten Komponentencodes - beispielsweise von der Art des genutzten Dienstes, der Rahmen- oder Blockstruktur, der verfügbaren Datenrate, der Qualität des Übertragungskanals - über die eine der Codiereinrichtung zugeordnete Steuerung STC über einen Rückkanal informiert wird - und von den Anforderungen an die Datensicherheit usw. bestimmt.

Auch können zusätzlich durch "dynamische" Selektion innerhalb einer Informationssequenz wichtige Bits oder Bitfolgen, beispielsweise spezielle Werte binär codierter Sprachsignale entsprechend ihrer Bedeutung für die Verständlichkeit, durch ungleichmäßige Zuordnung der Kontrollbits mit einem weiter vergrößerten Fehlerschutz versehen werden.

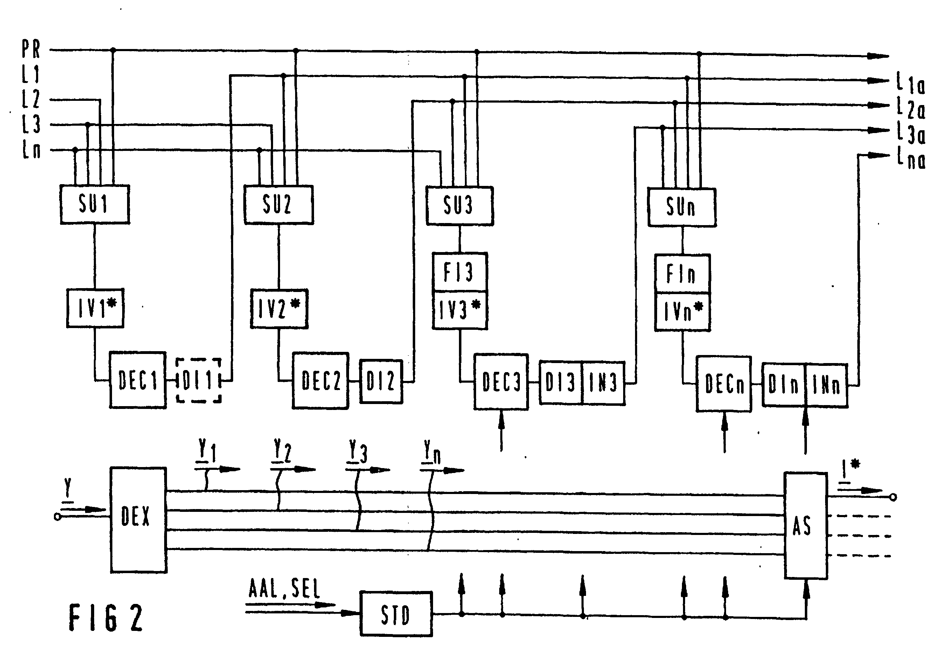

In **Figur 2** ist eine zugehörige Decodiereinrichtung DECE schematisch dargestellt, die zur Decodierung der seriellen Codefolge **X**ₛ geeignet ist. Sie enthält einen Demultiplexer DEX, dem die digitalisierten Abtastwerte **Y**ₛ der empfangenen seriellen Codefolge , die im störungsfreien Fall mit der gesendeten Codefolge **X**ₛ übereinstimmt, zugeführt wird und sie in Folgen **Y**₁ bis **Y**ₙ aufteilt. Sie besitzt weiter invers zu den Interleavern arbeitende Interleaver IV1* bis IVn*, Filter FI3* bis FIn*, deren Selektionsvorschrift exakt mit der Selektionsvorschrift der endcoderseitig verwendeten Filter übereinstimmt, und eine den Komponentencodern entsprechende Anzahl von Komponentendecoder DEC1 bis DECn, denen zu den Interleavern korrespondierende Deinterleaver DI1 bis DIn nachgeschaltet sind.

Den Decodern werden die digitalisierten Abtastwerte und über Summierschaltungen SU1 bis SUn die von den vorhergehenden Decoderstufen und zusätzlich die bei vorhergegangenen Iterationsschritten ermittelten Extrinsic-Komponenten L₁ bis Lₙ zugeführt. Über die Summierschaltungen kann auch zusätzlich eine "a priori-Information" PR mit Angaben über die zu decodierende Codefolge eingespeist werden.

Bei alternativen Darstellungen werden dem ersten Decoder der Decodiereinrichtung über den ersten Summierer die Informationsbits entsprechenden Abtastwerte und die Kontrollbits direkt zugeführt. Auf einen Interleaver kann bei einem (ersten) Coder und dem zugehörigen Decoder häufig verzichtet werden. Die Funktion des Decoders und der technische Aufbau der Codier- und Decodiereinrichtung ist dem Fachmann bekannt und in der Literatur ausreichend beschrieben.

Jeder Komponentendecoder verwendet entsprechend dem bekannten Schema von C. Berrou nur die Kanalinformation Y₁, Y₂, ...über die Codesymbole der empfangenen seriellen Codefolge Yₛ, die Teil des zu decodierenden Komponentencodes sind. Ebenso verwendet jeder Komponentendecoder auch nur die "a priori Information" Eigenschaften über die Informationsbits eben dieser Teilsequenz.

Die Komponentendecoder liefern jeweils nur eine dem entsprechenden Teil der decodierten Informationssequenz zugeordnete aktuelle Extrinsic-Information L₁ₐ bis Lₙₐ die an die folgenden Decoder geführt ist und deren Entscheidung verbessert.

Jeder zum jeweiligen mit einem Filter FI versehenen Interleaver IV korrespondierende Deinterleaver DI* wird um ein Einfüge-Modul IN3 bis INn erweitert, das in die Sequenz der ermittelten Extrinsic-Informationen an den Positionen der Informationsbits, die aufgrund der Selektion durch das Filter keine Elemente der Teilsequenz sind, Nullen einfügt.

Selbstverständlich müssen der Decodiereinrichtung DECE sowohl die Selektionsvorschriften, die Auswahlvorschriften der Filter als auch die Verwürfelungsvorschrift der Interleaver bekannt sein. Eine der Decodiereinrichtung zugeordnete Steuerung STD sorgt für eine entsprechende Verarbeitung der empfangenen Information.

Die Decodierung erfolgt in mehreren "Zyklen", bei denen die gewonnene zwischengespeicherte aktuelle Extrinsic-Information L₁ₐ bis Lₙₐ den Summierereingängen und die ebenfalls zwischengespeicherte Kanalinformation **Y**₁ bis **Y**ₙ den Decodern erneut zugeführt werden. Auf die Darstellung von Laufzeitgliedern usw. wurde verzichtet.

Die Entscheidung, welcher meist binäre Wert empfangen wurde, erfolgt aufgrund der Extrinsic-Information, z. B. EXTn des letzten Decoders der Decoderkette.

Wurden verwürfelte Informationbits empfangen, so muß die Verwürfelung selbstverständlich - hier in einer Ausgabestufe AS - rückgängig gemacht werden.

Die Decodiereinrichtung läßt sich in an sich bekannter Weise im Feed-back-oder Pipeline-Struktur realisieren.

Als Komponentencodes können beispielsweise Faltungscodes verwendet werden. In **Figur 3** ist ein Coder für einen rekursiven systematischen Code mit zwei binären Speicherstufen K1, K2 sowie zwei Modulo-2-Addierern H1 und H2 dargestellt. Über einen Dateneingang 1 gelangt jeweils eine Informationssequenz **I** = I₁, I₂, ...I_{L} bitweise zum Informationsausgang 2 und gleichzeitig zu einem Eingang des ersten Modulo-2-Addierers H1, dem außerdem die in den Speicherstufen K1, K2, dem Coder-Gedächtnis, vorliegenden Bits zugeführt werden. Das Ergebnis der Modulo-2-Addition wird dem Dateneingang der ersten Speicherstufe K1 zugeführt. Durch eine weitere Modulo-2-Addition der Modulo-2-Summe am Ausgang des ersten Modulo-2-Addierers H1 und der am Ausgang der zweiten Speicherstufe K2 anliegenden Information wird eine Kontrollsequenz P mit Kontrollbits P generiert und am Kontrollausgang 3 abgegeben. Die an den Ausgängen 2 und 3 anliegenden Codesymbole (Bits) werden in der Regel bitweise verschachtelt ausgesendet; bei weiteren Komponentencodern werden häufig nur die Kontrollbits ausgegeben.

Bei realisierten Übertragungseinrichtungen werden meist Coder mit mehr als zwei Speicherstufen verwendet.

Der Coder arbeitet in bekannter Weise mit einem Bittaktsignal, das in diesem Prinzipschaltbild nicht dargestellt ist.

Als Komponentencodes sind beispielsweise auch, insbesondere für die mit einem vorgeschalteten Filter versehenen Coder, Single-Parity-Check-Codes besonders geeignet, die in bekannter Weise eine Bitfolge, z. B. ein Codewort, mit einem Paritätsbit sichern. Durch die Verwendung von mindestens zwei dieser Komponentencodes wird ein einem Produktcode ähnlicher Fehlerschutz erreicht.

## Patentansprüche

1. Verfahren zum gesicherten Übertragen von Information mittels Mehrkomponenten-Codierung, bei der verkettete Informationssequenzen (*I*₁, *I*₂) mehreren Komponenten-Codern (COD1, COD2) zugeführt wird,
**dadurch gekennzeichnet,**
**daß** aus den Informationssequenzen (*I*) nach einem Auswahlalgorithmus wichtige Bits oder Bitfolgen zunächst ausgewählt werden und
**daß** diese weiteren Komponenten-Codern (COD3, ..., CODn) zugeführt und durch weitere Komponenten-Codes gesichert werden.

2. Verfahren nach Anspruch 1,
**dadurch gekennzeichnet,**
**daß** der Auswahlalgorithmus für die wichtigen Bits entsprechend unterschiedlichen Anforderungen änderbar ist.

3. Verfahren nach Anspruch 1,
**dadurch gekennzeichnet,**
**daß** die ausgewählten Bits oder Bitfolgen über Interleaver (IV1 bis IVn) geführt werden.

4. Verfahren nach Anspruch 2,
**dadurch gekennzeichnet,**
**daß** die Verwürfelungslänge der Interleaver (IV1 bis IVn) steuerbar ist.

5. Verfahren nach einem der vorhergehenden Ansprüche,
**dadurch gekennzeichnet,**
**daß** als Komponenten-Codes Faltungs-Codes verwendet werden.

6. Verfahren nach einem der vorhergehenden Ansprüche,
**dadurch gekennzeichnet,**
**daß** als weitere Komponenten-Codes Single-Parity-Check-Codes verwendet werden.

7. Verfahren nach einem der vorhergehenden Ansprüche,
**dadurch gekennzeichnet,**
**daß** aus den codierten Codefolgen (**X**₁ bis **X**ₙ) entsprechend wechselnden Anforderungen eine unterschiedliche Anzahl von Codersymbolen ausgewählt sind.

8. Verfahren nach einem der vorhergehenden Ansprüche,
**dadurch gekennzeichnet,**
**daß** aus den codierten Codefolgen (**X**₁ bis **X**ₙ) durch "dynamische" Selektion von Codesymbolen entsprechend die Redundanz ungleichmäßig über die Informationsbits verteilt und damit der ungleichmäßige Fehlerschutz verstärkt wird.

9. Codiereinrichtung zur Durführung des verfatens nach Anspruch 1, zur Erzeugung eines Mehrkomponentencodes mit mehreren Komponenten-Coder (COD1 bis COD2),
**dadurch gekennzeichnet,**
**daß** weitere Komponenten-Coder (COD3 bis CODn) vorgesehen sind, denen als Selektionsschaltungen wirkende Filter (FI3 bis FIn) zur Auswahl wichtiger Bits oder Bitfolgen vorgeschaltet sind.

10. Decodiereinrichtung zur Decodierung eines Mehrkomponentencodes mit mehreren Komponenten-Decoder (COD1 bis COD2),
**dadurch gekennzeichnet,**
**daß** weitere Komponenten-Decoder (DEC3 bis DECn) vorgesehen sind, denen als Selektionsschaltungen wirkende Filter (FI3* bis FIn*) zur Auswahl wichtiger Bits oder Bitfolgen vorgeschaltet sind.

## Claims

1. Method for secure transmission of information by means of multicomponent coding, in which linked information sequences (*I*₁, *I*₂) are supplied to a number of component coders (COD1, COD2),
**characterized**
**in that** important bits or bit sequences are first of all selected from the information sequences (*I*) using a selection algorithm, and
**in that** these are supplied to further component coders (COD3, ..., CODn) and are protected by further component codes.

2. Method according to Claim 1,
**characterized**
**in that** the selection algorithm for the important bits can be varied in accordance with different requirements.

3. Method according to Claim 1,
**characterized**
**in that** the selected bits or bit sequences are passed via interleavers (IV1 to IVn).

4. Method according to Claim 2,
**characterized**
**in that** the scrambling length of the interleavers (IV1 to IVn) is controllable.

5. Method according to one of the preceding claims,
**characterized**
**in that** convolution codes are used as component codes.

6. Method according to one of the preceding claims,
**characterized**
**in that** single parity check codes are used as the further component codes.

7. Method according to one of the preceding claims,
**characterized**
**in that** a different number of coder symbols is selected from the coded code sequences (X₁ to Xₙ) in accordance with changing requirements.

8. Method according to one of the preceding claims,
**characterized**
**in that** the redundancy is distributed in an appropriate manner nonuniformly over the information bits, from the coded code sequences (X₁ to Xₙ) by means of "dynamic" selection of code symbols, thus reinforcing the nonuniform error protection.

9. Coder device for carrying out the method according to Claim 1, for producing a multicomponent code with a number of component coders (COD1 to COD2)
**characterized**
**in that** further component coders (COD3 to CODn) are provided, upstream of which filters (FI3 to FIn) which act as selection circuits are located, in order to select important bits or bit sequences.

10. Decoder device for carrying out the method according to Claim 1 for decoding a multicomponent code with a number of component decoders (COD1 to COD2),
**characterized**
**in that** further component decoders (DEC3 to DECn) are provided, upstream of which filters (FI3* to FIn*) which act as selection circuits are located, in order to select important bits or bit sequences.

## Revendications

1. Procédé destiné à la transmission protégée d'informations au moyen d'un codage à composantes multiples, dans lequel les séquences enchaînées d'informations (*I*₁, *I*₂) sont appliquées à plusieurs codeurs à composantes (COD1, COD2)
**caractérisé par le fait**
**que**, à partir des séquences d'informations (*I*), d'abord des bits ou des suites de bits importants sont sélectionnés en suivant un algorithme de sélection et que ceux-ci sont appliqués à d'autres codeurs à composantes (COD3, ..., CODn) et protégés par d'autres codes à composantes.

2. Procédé selon la revendication 1
**caractérisé par le fait**
**que** l'algorithme de sélection peut être modifié pour les bits importants en fonction d'exigences différentes.

3. Procédé selon la revendication 1
**caractérisé par le fait**
**que** les bits ou les suites de bits sélectionnés sont envoyés à travers des entrelaceurs ou interleavers (IV1 à IVn).

4. Procédé selon la revendication 2
**caractérisé par le fait**
**que** la longueur de cryptage des entrelaceurs (IV1 à IVn) peut être contrôlée.

5. Procédé selon l'une des revendications précédentes
**caractérisé par le fait**
**que** des codes à convolution sont utilisés comme codes à composantes.

6. Procédé selon l'une des revendications précédentes
**caractérisé par le fait**
**que** des codes à contrôle de parité simple sont utilisés comme autres codes à composantes.

7. Procédé selon l'une des revendications précédentes
**caractérisé par le fait**
**qu'**un nombre variable de symboles codés sont sélectionnés parmi les suites codées (**X**₁ à **X**ₙ) en fonction d'exigences qui varient.

8. Procédé selon l'une des revendications précédentes
**caractérisé par le fait**
**que**, parmi les suites codées (**X**₁ à **X**ₙ), grâce à une sélection "dynamique" de symboles codés, la redondance est répartie, d'une façon correspondante, irrégulièrement sur les bits d'information et, ainsi, la protection contre les erreurs est renforcée d'une façon irrégulière.

9. Dispositif de codage, destiné à l'exécution du procédé selon la revendication 1 ainsi qu'à la génération d'un code à composantes multiples, ayant plusieurs codeurs à composantes (COD 1 à COD2)
**caractérisé par le fait**
**qu'**il est prévu d'autres codeurs à composantes (COD3 à CODn), avant lesquels sont connectés des filtres (FI3 à FIn), agissant comme circuits de sélection et destinés à sélectionner des bits ou des suites de bits importants.

10. Dispositif de décodage, destiné à l'exécution du procédé selon la revendication 1 ainsi qu'au décodage d'un code à composantes multiples, ayant plusieurs décodeurs à composantes (COD 1 à COD2)
**caractérisé par le fait**
**qu'**il est prévu d'autres décodeurs à composantes (DEC3 à DECn), avant lesquels sont connectés des filtres (FI3* à FIn*), agissant comme circuits de sélection et destinés à sélectionner des bits ou des suites de bits importants.
